# EUROPEAN PATENT APPLICATION

(11) **EP 2 397 785 A2**
(43) Date of publication of application: **21.12.2011**
(21) Application number: 11169121.8
(22) Date of filing: 08.06.2011
(51) Int. Cl.: F24F 11/00, H05K 7/20

(54) **Air conditioning method for data processing equipment rooms and installation for carrying out said method**

(30) Priority: 09.06.2010 ES 201000760
(71) Applicant: Gesab, S.A., 08450 Llinars del Vallès, Barcelona (ES)
(72) Inventor: Marmol Mateos, Francisco Daniel, 28817 Madrid (ES)
(74) Representative: Intès, Didier Gérard André

(57) **Abstract**

The present invention relates to an air conditioning method for data processing equipment rooms and an installation for carrying out said method, determining inlet and outlet air circulation between the interior and the exterior of the room of application by means of an extraction and absorption unit (3), and recirculation of the interior air of the room through a cooling unit (4), combining both activities by means of automatic control, which determines the individual actuation of one activity or the other or of both at the same time, according to exterior temperature ranges.

## Description

### Field of the Art

The present invention relates to air conditioning for maintaining suitable environmental conditions in data processing equipment rooms, proposing a system which optimizes energy consumption by means of combining air inlet and outlet circulation with respect to the exterior and recirculation of the interior air, performing the conditioning function in particular conditions for different exterior temperature ranges.

### State of the Art

Data processing equipment generates, in its operation, heat which accumulates, so cooling is necessary, preventing the increase of the temperature up to values that are detrimental for the operation or conservation of the equipment.

The heat generated by the apparatuses of the equipment affects the environment of the whole in data processing equipment rooms, such that it is necessary to continuously condition the air in said rooms in order to keep the temperature and humidity at values suitable for the operation and the conservation of the equipment installed within the rooms.

The conditioning of the air in data processing equipment rooms is traditionally done by means of recirculating the interior air of the room through a cooling unit, which requires the continuous treatment of a large volume of air, resulting in a very high consumption of the cooling unit.

### Object_of the Invention

A system for conditioning the air in data processing equipment rooms is proposed according to the invention, whereby an effective action of the environmental conditioning of the rooms of application with considerably reduced energy consumption is achieved.

This system object of the invention comprises an air inlet and outlet circulation between the interior of the room of application and the exterior by means of an extraction and absorption unit and recirculation of the interior air of the room through a cooling unit, combining both operative forms according to exterior temperature ranges.

The operation of the operative forms of the system is established by means of an automatic control which acts according to the signals from probes for measuring the temperature in the exterior and interior of the room of operation, such that in a low exterior temperature range, in the order of between -5°C and 14°C, operation of the air inlet and outlet with respect to the exterior is established by means of the extraction and absorption unit, the recirculation through the cooling unit remaining inactive; in an intermediate exterior temperature range, in the order of between 14°C and 21°C, simultaneous operation of the two operative forms of the system is established; and in a high exterior temperature range, above a value in the order of 21°C, operation of the recirculation of the interior air through the cooling unit is established, the air circulation with respect to the exterior remaining inactive.

A system is thereby obtained which uses the exterior air for cooling the interior environment of the room of application when the exterior temperature is low, without any consumption by the cooling unit; whereas when the exterior temperature is of a value comprised in an intermediate range, the temperature of the interior of the room of application is cooled by means of the combined action of the exterior air and the cooling unit, therefore the action of the cooling unit only partially being used; whereas when the exterior temperature exceeds a determined value, the interior of the room of application is cooled only by means of recirculating the interior air through the cooling unit.

Global energy consumption for cooling a room is therefore significantly reduced because the energy consumption is primarily determined by the operation of the cooling unit, which is only used when the exterior temperature of the room of application is at determined values.

The air extraction and absorption unit comprises an outlet duct and an inlet duct, provided with air blower fans, respective openable hatches for communication with the exterior of the room to be cooled being arranged with respect to said ducts, whereas another openable communication hatch is included between said ducts, by means of which hatches the air passage opening and closure, as appropriate, is established for the operation of the system in the operative forms corresponding to the different exterior temperature ranges.

The system of the invention therefore presents advantageous features for the function for which it is intended, acquiring it own identity and preferred nature with respect to conventional systems used for the same application.

### Description of the Drawings

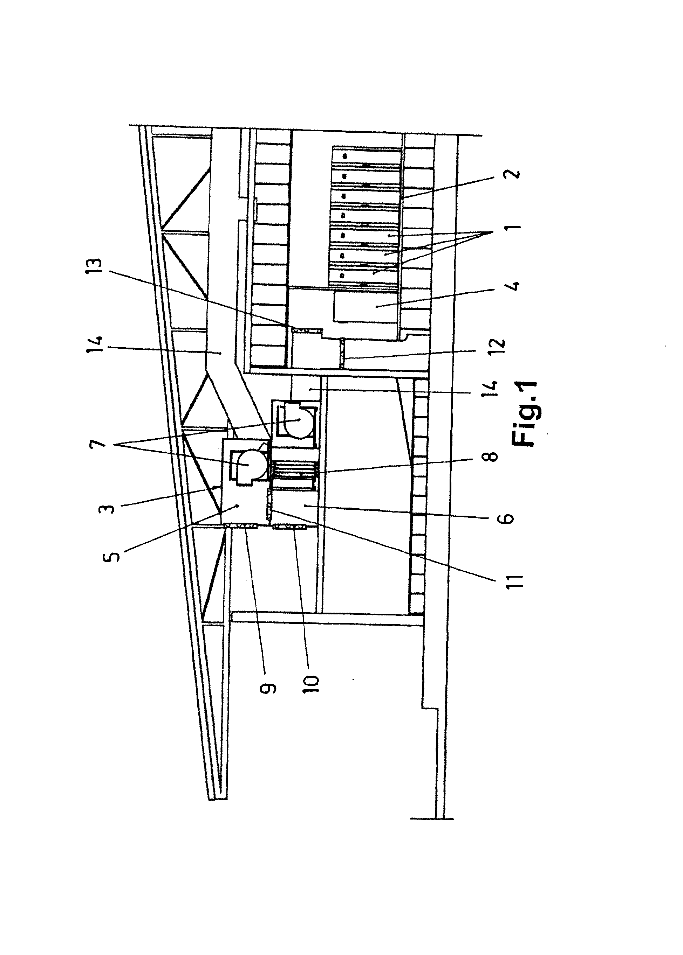

Figure 1 schematically shows a partial view of a data processing equipment room equipped with the proposed air conditioning system.
Figure 2 is the same view as in the previous drawing indicating the operation of the air conditioning system in an exterior temperature range of, for example, between -5°C and 9°C.
Figure 3 is the same view indicating the operation of the air conditioning system in an exterior temperature range of, for example, between 9°C and 14°C.
Figure 4 is the same view indicating the operation of the air conditioning system in an exterior temperature range of, for example, 14°C and 21°C.
Figure 5 is the same view indicating the operation of the air conditioning system when the temperature of the exterior of the room of application exceeds 21°C.

### Detailed Description of the Invention

The object of the invention relates to an air conditioning system for data processing equipment rooms, whereby a cooling air flow is passed through the data processing equipment (1), for example through a raised floor (2), determining said cooling air flow by means of a combined operation of air circulation between the interior and the exterior of the room of application and recirculation of the interior air of the room.

The air circulation between the interior and the exterior of the room is performed by means of an extraction and absorption unit (3), whereas the recirculation of the interior air of the room is performed through a cooling unit (4), both air flows entering through the lower part of the raised floor (2) in order to rise, passing through the data processing equipment (1), driving out the heat therefrom.

The cooling unit (4) is a unit of the type conventionally used for conditioning ambient air in enclosures or rooms of application by means of recirculation.

The extraction and absorption unit (3) comprises an air outlet duct (5) for the outlet of the air from the interior of the room of application to the exterior, and an air inlet duct (6) for the inlet of the air from the exterior to the interior of the room, air blower fans (7) being arranged in both ducts (5 and 6), and an air filtration and adiabatic humidification group (8) also being arranged in the air inlet duct (6) for the inlet of the air from the exterior.

The air outlet duct (5) and the air inlet duct (6), have respective openable communication hatches (9 and 10) with respect to the exterior, whereas communication between both ducts (5 and 6) is provided with another practicable hatch (11); whereas there are two communication paths in turn provided with respective openable hatches (12 and 13) between the air inlet duct (6) and the interior of the room of application, the first being a direct communication path towards the lower part of the raised floor (2) and the second being a communication path towards the cooling unit (4).

The entire functional assembly of the conditioning system is controlled automatically by an electronic system according to the signals provided by several probes for measuring the temperature-humidity in the exterior and interior of the room of operation as well as in the supply and extraction conduits (14), starting up the inlet and outlet air circulation with respect to the exterior, and/or the recirculation of the interior air, in combination with the opening and closure of each of the openable hatches (9, 10, 11, 12 and 13), as appropriate, for the operation of the conditioning system according to the exterior temperature.

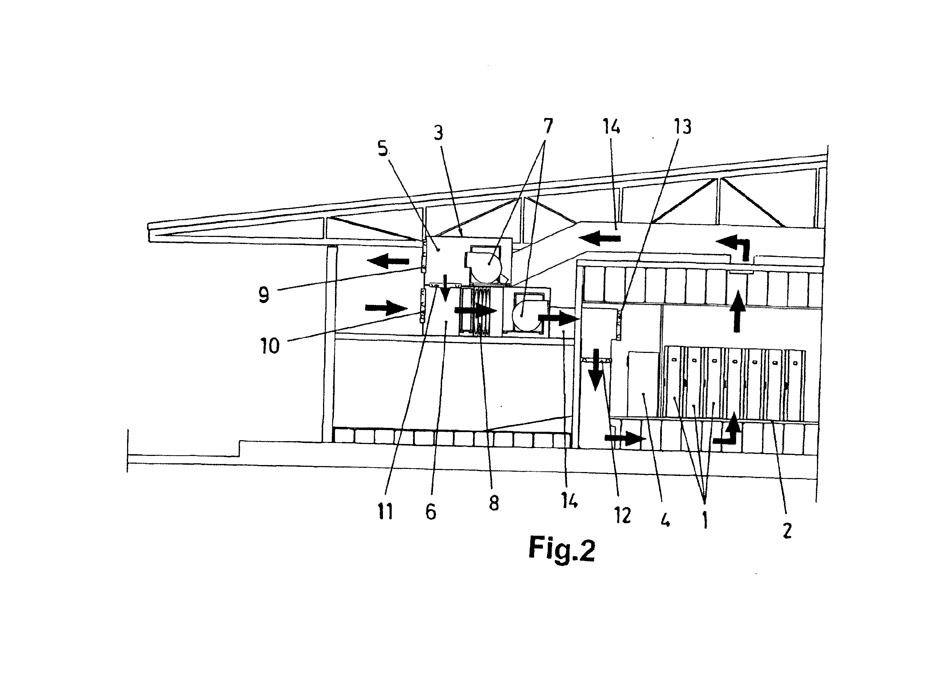

As a result, an operative form is provided for an exterior temperature range between -5°C and 9°C, with the extraction and absorption unit (3) operating, the openable hatches (9, 10, 11 and 12) being open, whereas the openable hatch (13) remains closed and the cooling unit (4) inactive, such that, as is observed in Figure 2, air circulation from the interior of the chamber towards the exterior through the duct (5) and from the exterior towards the interior through the duct (6) takes place, while at the same time part of the air which is extracted from the interior passes from the outlet duct (5) to the inlet duct (6), through the openable hatch (11), the air that is introduced into the chamber entering through the lower part of the raised floor (2) to then exit through the upper part. In other words, in this case, the conditioning takes place by mixing air from of the interior of the room with air that is introduced from the exterior, without complementary cooling.

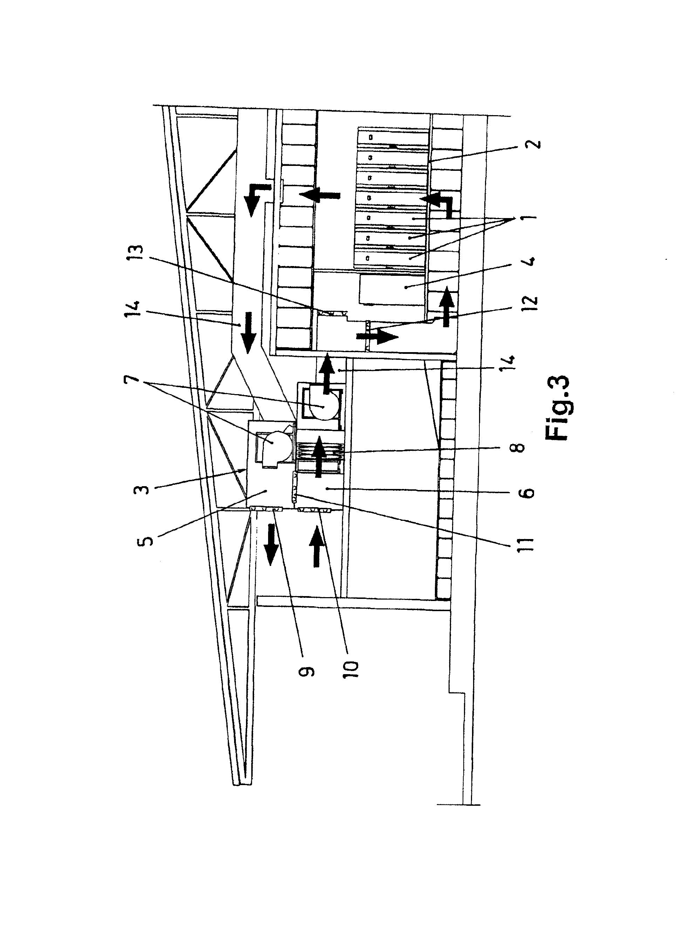

In an exterior temperature range between 9°C and 14°C, the operation is in the same conditions, but with the openable hatch (11) closed, i.e., all the air that is extracted from the chamber is sent to the exterior through the practicable hatch (9) and all the air that is introduced is taken from the exterior through the openable hatch (10), as is observed in Figure 3. In other words, in this case, the conditioning takes place only with air that is introduced from the exterior, without complementary cooling.

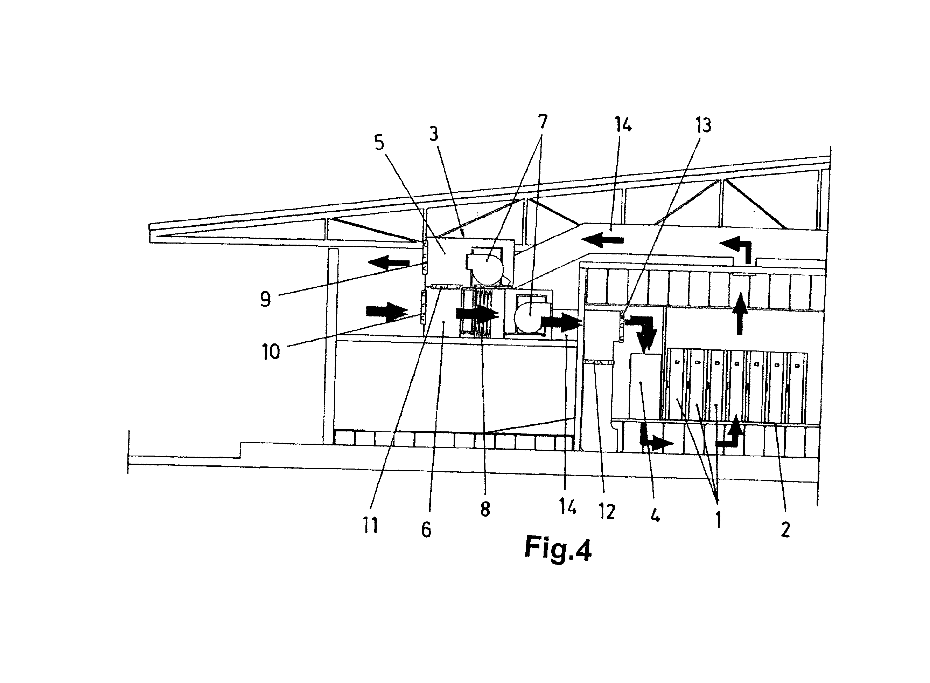

In an exterior temperature range between 14°C and 21°C, all the air that is extracted from the chamber is sent to the exterior and all the air that is introduced is taken from the exterior, as in the previous range, but with openable hatch (12) closed and openable hatch (13) open, the extraction and absorption unit (3) and the cooling unit (4) operating at the same time such that the air which is introduced passes through the cooling unit (4) towards the lower part of the raised floor (2), as is observed in Figure 4. In other words in this case, the conditioning takes place with air which is introduced from the exterior, passing through a complementary cooling.

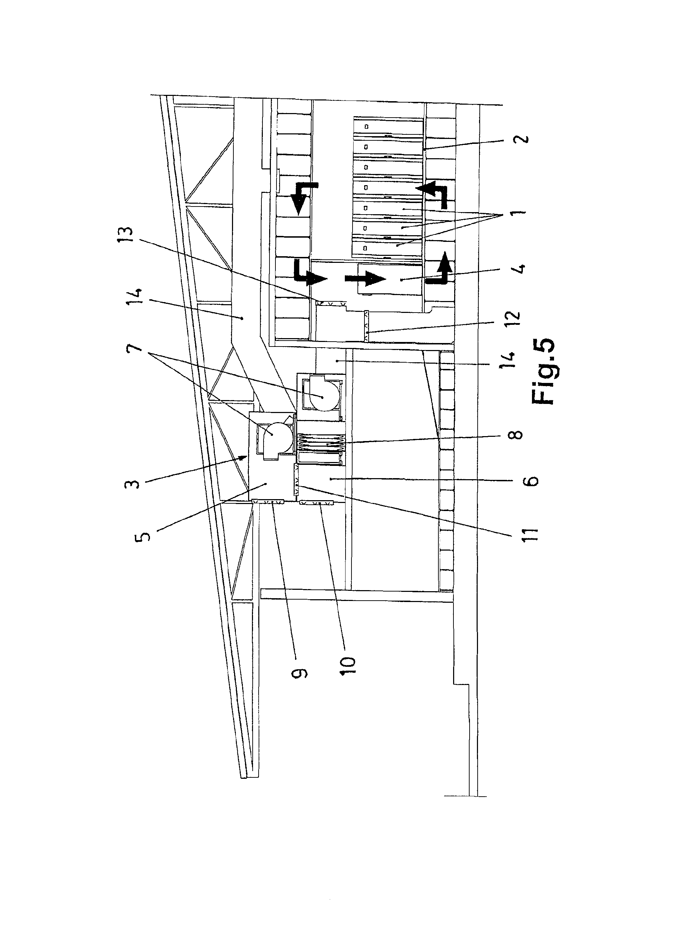

When the exterior temperature exceeds 21°C, the extraction and absorption unit (3) remains inactive and the cooling unit (4) continues operating, the interior air of the room being recirculated through the cooling unit (4), as is observed in Figure 5. In other words, in this case, air inlet and outlet circulation with respect to the exterior does not take place because the influence of the exterior air is not significant for maintaining the necessary conditions of the interior environment of the room and therefore it is not worth it to have the extraction and absorption unit (3) operating.

The cooling unit (4) thereby only operates in its entirety when the exterior temperature of the chamber of application exceeds a determined value and in an exterior temperature range under that value, said cooling unit (4) only operates partially, whereby the overall consumption of the conditioning system is very low with respect to conventional systems performing conditioning only by means of recirculation with cooling of the interior air of the chambers of application.

The indicated exterior temperature ranges for the operation of the system in the different operative forms must be interpreted as practical, non-limiting examples because the exterior temperature ranges for which the different operative forms of the system are determined may vary according to the structural features and dimensions of the rooms of application and the data processing equipment (1) installed therein.

At an exterior temperature below -5°C, the air extraction and absorption unit (3) may experience defrosting problems and blockages may occur in the air inlet, and damages to the filtration and humidification group (8) may also occur due to blowing air with ice fragments, so in this exterior temperature range the operation of said air extraction and absorption unit (3) between the interior and the exterior of the chamber of application is not advisable.

## Claims

1. An air conditioning method for data processing equipment rooms, of the type intended for cooling the data processing equipment (1) installed in the rooms of application and maintaining the interior environment of said rooms in conditions suitable for the operation and conservation of the data processing equipment (1), **characterized in that** it comprises inlet and outlet air circulation between the interior and the exterior of the room of application by means of an extraction and absorption unit (3) and recirculation of the interior air of the room through a cooling unit (4), combining both activities by means of automatic control according to exterior temperature ranges, such that in a low range of said exterior temperature in the order of between 5°C and 14°C, only the inlet and outlet air circulation between the interior and the exterior of the room acts, whereas in a intermediate exterior temperature range in the order of between 14°C and 21°C, the inlet and outlet air circulation with respect to the exterior and the recirculation of the interior air of the room act together, whereas above a determined value of the exterior temperature in the order of 21°C, only the recirculation of the interior air of the room functions.

2. An air conditioning installation for carrying out the method of claim 1, comprising an extraction and absorption unit (3) for performing inlet and outlet air circulation between the interior and the exterior of the room of application, and a cooling unit (4) for performing recirculation of the interior air of the room through it, **characterized in that** the air extraction and absorption unit (3) comprises an air outlet duct (5) and an air inlet duct (6), provided with air blower fans (7), respective openable communication hatches (9 and 10) with respect to the exterior of the room of application being arranged with respect to said ducts, whereas an openable communication hatch (11) is included between both ducts (5 and 6).

3. The air conditioning installation according to claim 2, **characterized in that** two communication paths provided with respective openable hatches (12 and 13) are arranged between the air inlet duct (6) of the extraction and absorption unit (3) and the interior of the chamber of application, the first being a direct communication path towards the lower part of a raised floor (2) above which the data processing equipment (1) is located and the second being a communication path towards the cooling unit (4), from where the air in turn passes towards the lower part of the raised floor (2).

4. The air conditioning installation according to claim 2, **characterized in that** an air filtration and adiabatic humidification group (8) that is introduced from the exterior towards the interior of the chamber of application is included in the air inlet duct (6) of the unit (3).
